# EUROPEAN PATENT APPLICATION

(11) **EP 4 250 349 A1**
(43) Date of publication of application: **27.09.2023**
(21) Application number: 20965452.4
(22) Date of filing: 16.12.2020
(51) Int. Cl.: H01L 23/31, H01L 21/56, H01L 23/29

(54) **CHIP PACKAGE AND PREPARATION METHOD THEREFOR**

(71) Applicant: Huawei Technologies Co., Ltd., Shenzhen, Guangdong 518129 (CN)
(72) Inventor: HU, Xiao, Shenzhen, Guangdong 518129 (CN); ZHAO, Nan, Shenzhen, Guangdong 518129 (CN)
(74) Representative: Gill Jennings & Every LLP
(86) International application number: PCT/CN2020/136865
(87) International publication number: WO 2022/126434

(57) **Abstract**

Embodiments of this application provide a chip package and a chip package preparation method, to help improve performance of a chip. The chip package includes a substrate, a die, a first protection structure, and a blocking structure. The die, the first protection structure, and the blocking structure are all disposed on a first surface of the substrate. The first protection structure wraps a side surface of the die, the blocking structure wraps a surface that is of the first protection structure and that is away from the die, and a first surface of the die, a first surface of the first protection structure, and a first surface of the blocking structure are flush. The first surface of the die is a surface that is of the die and that is away from the substrate, the first surface of the first protection structure is a surface that is of the first protection structure and that is away from the substrate, and the first surface of the blocking structure is a surface that is of the blocking structure and that is away from the substrate.

## Description

### TECHNICAL FIELD

This application relates to the field of semiconductor technologies, and in particular, to a chip package and a chip package preparation method in the field of semiconductor technologies.

### BACKGROUND

In a semiconductor packaging technology, a flip chip technology is a common packaging technology. The flip chip technology is a technology in which a tin-lead ball is deposited on an input/output (I/O) pad of a die, then the die is turned over and heated, and a fused tin-lead ball is combined with a packaging substrate.

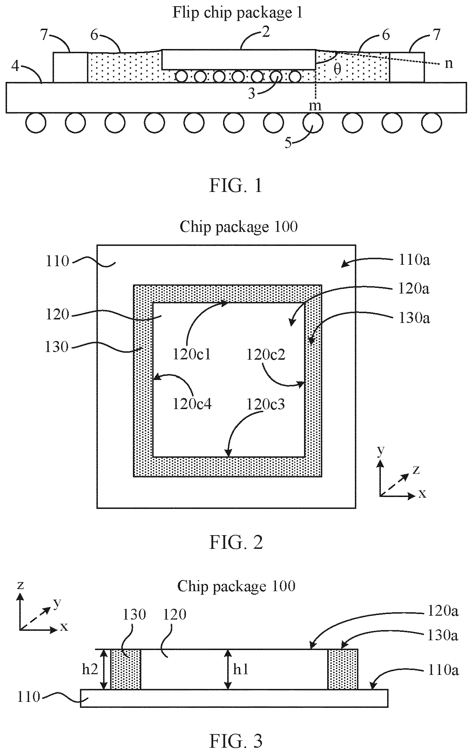

To further improve a heat dissipation capability of the die, the die soldered on the packaging substrate may be exposed. Patent application No. US 2002/0060084A1 protects a flip chip package for stress control, and discloses a flip chip package 1 shown in FIG. 1. As shown in FIG. 1, the chip package 1 includes a die 2, the die 2 has a contact 3, the contact 3 is connected to a conductive wire (not shown) on a substrate 4, and the conductive wire connects the contact 3 to an external terminal (solder ball) 5 of the substrate 4. The chip package 1 further includes a dam 7 surrounding the die 2 and controlling a shape of an edge of a bottom filler 6. The bottom filler 6 is formed by adding a bottom filling agent under the die 2 and within a limited volume range of the dam 7 and solidifying the bottom filling agent.

However, because the bottom filling agent is liquid, and the die 2 is a solid, at a contact position between the die 2 and the bottom filling agent, there is an included angle (that is, a wetting angle) between a tangent m of a solid-state surface and a tangent n of a liquid-state surface. Therefore, the bottom filler 6 formed by solidifying the bottom filling agent also has such an included angle. In this case, an edge and a corner of the die 2 are exposed outside the bottom filler 6, that is, the edge and the corner of the die 2 are not protected.

Therefore, for the flip chip package shown in FIG. 1, in a scenario in which a heat sink is provided for the die or a scenario in which the entire package vibrates or falls, the die is likely to be damaged, affecting performance of the die.

### SUMMARY

Embodiments of this application provide a chip package and a chip package preparation method, to protect a die and further improve performance of the die.

According to a first aspect, an embodiment of this application provides a chip package, including a substrate, a die, a first protection structure, and a blocking structure. The die, the first protection structure, and the blocking structure are all disposed on a first surface of the substrate. The first protection structure wraps a side surface of the die, the blocking structure wraps a surface that is of the first protection structure and that is away from the die, and a first surface of the die, a first surface of the first protection structure, and a first surface of the blocking structure are flush. The first surface of the die is a surface that is of the die and that is away from the substrate, the first surface of the first protection structure is a surface that is of the first protection structure and that is away from the substrate, and the first surface of the blocking structure is a surface that is of the blocking structure and that is away from the substrate.

In the chip package provided in this embodiment of this application, the first protection structure wraps the side surface of the die, so that the die can be protected. The first surface of the die is flush with the first surface of the first protection structure, so that both an edge and a corner of the die are wrapped by the first protection structure, and more complete protection can be achieved. In addition, in a scenario in which a heat sink is provided for the die or a scenario in which an entire package vibrates or falls, the chip package provided in this embodiment of this application can avoid a case that the die cracks due to uneven stress caused by collision of the package or another device (for example, a heat sink disposed above the first surface of the die) on the die. Therefore, reliability and safety of the die can be improved by using the chip package 100 provided in this embodiment of this application.

In addition, the first surface of the die is flush with the first surface of the first protection structure, so that it can be ensured that the surface of the die is not covered by the surface of the first protection structure. In addition, because a material of the first protection structure is a high-thermally-conductive material, the surface may be equivalent to a surface extension, so that a heat dissipation area of the die can be increased, thereby improving a heat dissipation capability of the die.

In conclusion, the chip package provided in this embodiment of this application can improve performance of the die.

It should be noted that, in this embodiment of this application, that the first protection structure wraps the side surface of the die may be understood as that a surface that is of the first protection structure and that is close to the die touches a surface that is of the die and that is close to the first protection structure.

In a possible implementation, a second protection structure is added between the substrate and the die.

In the chip package provided in this embodiment of this application, the second protection structure is added between the substrate and the die, so that a case in which the die cracks due to uneven stress caused by a material difference between the substrate and the die can be avoided. In addition, a pad of the substrate and the die and a solder ball used for an electrical connection to the pad can be prevented from being polluted by moisture or other impurities, thereby improving reliability and safety of the chip package.

In a possible implementation, a material of the first protection structure is different from a material of the second protection structure.

In a possible implementation, viscosity of the material of the first protection structure is greater than viscosity of the material of the second protection structure.

It should be noted that the first protection structure is mainly used to fasten and protect the die, and the second protection structure is mainly used to fill a gap between the substrate and the die and reduce impact on the die caused due to stress brought by a material difference between the die and the substrate. Therefore, the material of the first protection structure may have higher viscosity, and the material of the second protection structure may have lower viscosity. In other words, the viscosity of the material of the first protection structure may be greater than the viscosity of the material of the second protection structure.

In a possible implementation, there are a plurality of dies, and orthographic projections of the plurality of dies on the first surface of the substrate do not overlap with each other.

In the chip package provided in this embodiment of this application, one first protection structure and one blocking structure may protect a plurality of dies, so that manufacturing process complexity and manufacturing costs can be reduced.

In a possible implementation, there are a plurality of first protection structures, each of the plurality of first protection structures wraps at least one of the plurality of dies, and different first protection structures wrap different dies.

In a possible implementation, there are a plurality of blocking structures, a quantity of the plurality of blocking structures is equal to a quantity of the plurality of first protection structures, and the plurality of blocking structures separately wrap the plurality of first protection structures.

It should be noted that, when first surfaces of some or all of the plurality of dies are not flush, an independent first protection structure and an independent blocking structure are disposed for at least one die with a flush first surface in the plurality of dies, to ensure that each die and an edge of a first protection structure that wraps the die are completely covered, thereby ensuring heat dissipation performance and stability of each die, and improving reliability of the chip package.

According to a second aspect, an embodiment of this application further provides an integrated circuit, including a printed circuit board PCB and the chip package according to the first aspect or any possible implementation of the first aspect that is disposed on the PCB.

According to a third aspect, an embodiment of this application further provides a chip package preparation method, including: disposing a die on a first surface of a substrate; disposing a first blocking structure around a side surface of the die on the first surface of the substrate, where there is a gap between the first blocking structure and the die, a distance between a first surface of the first blocking structure and the first surface of the substrate is greater than a distance between a first surface of the die and the first surface of the substrate, the first surface of the first blocking structure is a surface that is of the first blocking structure and that is away from the substrate, and the first surface of the die is a surface that is of the die and that is away from the substrate; filling the gap between the first blocking structure and the die with a first filling material, until a first surface of the first filling material is flush with the first surface of the first blocking structure, where the first surface of the first filling material is a surface that is of the first filling material and that is away from the substrate; heating and solidifying the first filling material to form a third protection structure; and grinding a first surface of the third protection structure and the first surface of the first blocking structure, until the first surface of the die is exposed.

In a possible implementation, before the filling the gap between the first blocking structure and the die with a first filling material, the preparation method further includes: adding a second filling material between the die and the substrate; and heating and solidifying the second filling material to form a second protection structure.

In a possible implementation, a material of the third protection structure is different from a material of the second protection structure.

In a possible implementation, viscosity of the material of the third protection structure is greater than viscosity of the material of the second protection structure.

In a possible implementation, there are a plurality of dies, and the disposing a die on a first surface of a substrate includes: disposing the plurality of dies on the first surface of the substrate, where orthographic projections of the plurality of dies on the first surface of the substrate do not overlap with each other.

In a possible implementation, there are a plurality of first blocking structures, and the disposing a first blocking structure around a side surface of the die on the first surface of the substrate includes: disposing the plurality of first blocking structures on the first surface of the substrate, where each of the plurality of first blocking structures surrounds a side surface of at least one of the plurality of dies, and a different first blocking structure surrounds different dies.

In a possible implementation, the filling the gap between the first blocking structure and the die with a first filling material includes: filling, with the first filling material, a gap between each first blocking structure and the at least one die surrounded by each first blocking structure.

### BRIEF DESCRIPTION OF DRAWINGS

FIG. 1 is a schematic diagram of a structure of a flip chip package 1 in the conventional technology;
FIG. 2 is a schematic diagram of a structure of a chip package 100 according to an embodiment of this application;
FIG. 3 is another schematic diagram of a structure of a chip package 100 according to an embodiment of this application;
FIG. 4 is still another schematic diagram of a structure of a chip package 100 according to an embodiment of this application;
FIG. 5 is a schematic diagram of a structure of a chip package 200 according to an embodiment of this application;
FIG. 6 is a schematic diagram of an electrical connection between a substrate and a die according to an embodiment of this application;
FIG. 7 is another schematic diagram of an electrical connection between a substrate and a die according to an embodiment of this application;
FIG. 8 is a schematic diagram of a structure of a chip package 300 according to an embodiment of this application;
FIG. 9 is another schematic diagram of a structure of a chip package 300 according to an embodiment of this application;
FIG. 10 is still another schematic diagram of a structure of a chip package 300 according to an embodiment of this application;
FIG. 11 is yet another schematic diagram of a structure of a chip package 300 according to an embodiment of this application;
FIG. 12 is still yet another schematic diagram of a structure of a chip package 300 according to an embodiment of this application;
FIG. 13 is a further schematic diagram of a structure of a chip package 300 according to an embodiment of this application;
FIG. 14 is a schematic flowchart of a preparation method 400 according to an embodiment of this application;
FIG. 15 is another schematic flowchart of a preparation method 400 according to an embodiment of this application;
FIG. 16 is a schematic flowchart of a preparation method 600 according to an embodiment of this application; and
FIG. 17 is a schematic diagram of a structure of an integrated circuit 800 according to an embodiment of this application.

### DESCRIPTION OF EMBODIMENTS

The following describes technical solutions of this application with reference to the accompanying drawings.

To resolve a problem that performance of a die is poor in the conventional technology, an embodiment of this application provides a chip package, to protect the die and further improve the performance of the die.

FIG. 2 and FIG. 3 are schematic diagrams of a structure of a chip package 100 according to an embodiment of this application. FIG. 2 is a top view, and FIG. 3 is a front view.

In FIG. 2 and FIG. 3, the chip package 100 may include a substrate 110, a die 120, and a first protection structure 130. Both the die 120 and the first protection structure 130 are disposed on a surface 110a of the substrate 110 (that is, a first surface of the substrate). The first protection structure 130 wraps a side surface of the die 120, and a surface 120a of the die 120 (that is, a first surface of the die) is flush with a surface 130a of the first protection structure 130 (that is, a first surface of the first protection structure). The surface 120a is a surface that is of the die 120 and that is away from the substrate 110, and the surface 130a is a surface that is of the first protection structure 130 and that is away from the substrate 110.

It should be noted that the die 120 refers to a unit that is not packaged after a cut test is performed on a wafer.

Optionally, an orthographic projection of the die 120 on the surface 110a may be in a plurality of shapes. This is not limited in this embodiment of this application.

In a possible implementation, as shown in FIG. 2, the orthographic projection of the die 120 on the surface 110a may be a quadrilateral.

It should be noted that the side surface of the die 120 in this embodiment of this application may include a surface that is of the die 120 and that extends in a z-axis direction in FIG. 2 or FIG. 3.

For example, as shown in FIG. 2, the side surface of the die 120 may include a surface 120c1, a surface 120c2, a surface 120c3, and a surface 120c4.

It should be further noted that, in this embodiment of this application, that the first protection structure 130 wraps the side surface of the die 120 may be understood as that a surface that is of the first protection structure 130 and that is close to the die 120 touches a surface that is of the die 120 and that is close to the first protection structure 130.

Optionally, an orthographic projection of the first protection structure 130 on the surface 110a may be in a plurality of shapes. This is not limited in this embodiment of this application.

In a possible implementation, as shown in FIG. 2, the orthographic projection of the first protection structure 130 on the surface 110a may be in a square-ring shape.

In other words, an orthographic projection, on the surface 110a, of a surface that is of the first protection structure 130 and that is away from the die 120 is a quadrilateral.

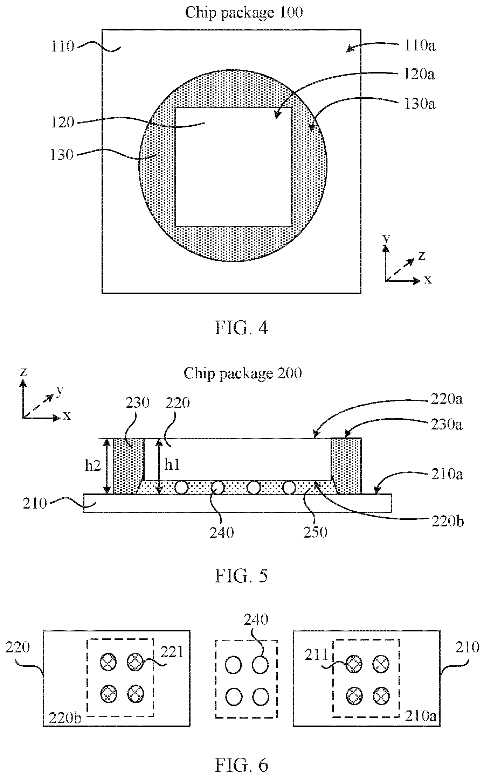

In another possible implementation, as shown in FIG. 4, the orthographic proj ection of the first protection structure 130 on the surface 110a may be in a ring shape that is round outside but square inside.

In other words, an orthographic projection, on the surface 110a, of a surface that is of the first protection structure 130 and that is away from the die 120 is a circle.

In a possible implementation, as shown in FIG. 3, that the surface 120a of the die 120 is flush with the surface 130a of the first protection structure 130 may be understood as follows: A distance h1 between the surface 120a of the die 120 and the surface 110a of the substrate 110 is equal to a distance h2 between the surface 130a of the first protection structure 130 and the surface 110a of the substrate 110.

In a possible implementation, a material of the first protection structure 130 may be a high-thermally-conductive material.

In the chip package 100 provided in this embodiment of this application, the first protection structure 130 wraps the side surface of the die 120, so that the die 120 can be protected. The surface 120a of the die 120 is flush with the surface 130a of the first protection structure 130, so that both an edge and a corner of the die 120 are wrapped by the first protection structure 130, and more complete protection can be achieved. In addition, in a scenario in which a heat sink is provided for the die or a scenario in which an entire package vibrates or falls, the chip package 100 can avoid a case that the die 120 cracks due to uneven stress caused by collision of the package or another device (for example, a heat sink disposed above the surface 120a of the die 120) on the die 120. Therefore, reliability and safety of the die 120 can be improved by using the chip package 100 provided in this embodiment of this application.

In addition, the surface 120a of the die 120 is flush with the surface 130a of the first protection structure 130, so that it can be ensured that the surface 120a of the die 120 is not covered by the surface 130a of the first protection structure 130. In addition, because the material of the first protection structure 130 is the high-thermally-conductive material, the surface 130a may be equivalent to an extension of the surface 120a, so that a heat dissipation area of the die 120 can be increased, thereby improving a heat dissipation capability of the die 120.

In conclusion, the chip package provided in this embodiment of this application can improve performance of the die.

Optionally, the die 120 may be disposed on the substrate 110 in a plurality of manners. This is not limited in this embodiment of this application.

In a possible implementation, FIG. 5 is a schematic diagram of a structure of a chip package 200 according to an embodiment of this application. As shown in FIG. 5, the chip package 200 may include a substrate 210, a die 220, and a first protection structure 230. Both the die 220 and the first protection structure 230 are disposed on a surface 210a of the substrate 210 (that is, a first surface of the substrate).

The first protection structure 230 wraps a side surface of the die 220. A surface 220a of the die 220 (that is, a first surface of the die) is flush with a surface 230a of the first protection structure 230 (that is, a first surface of the first protection structure). The surface 220a is a surface that is of the die 220 and that is away from the substrate 210, and the surface 230a is a surface that is of the first protection structure 230 and that is away from the substrate 210. A solder ball 240 is disposed on a surface 220b of the die 220, and the die 220 is soldered on the substrate 210 by using the solder ball 240. The surface 220b of the die 220 is a surface that is of the die 220 and that is close to the substrate 210.

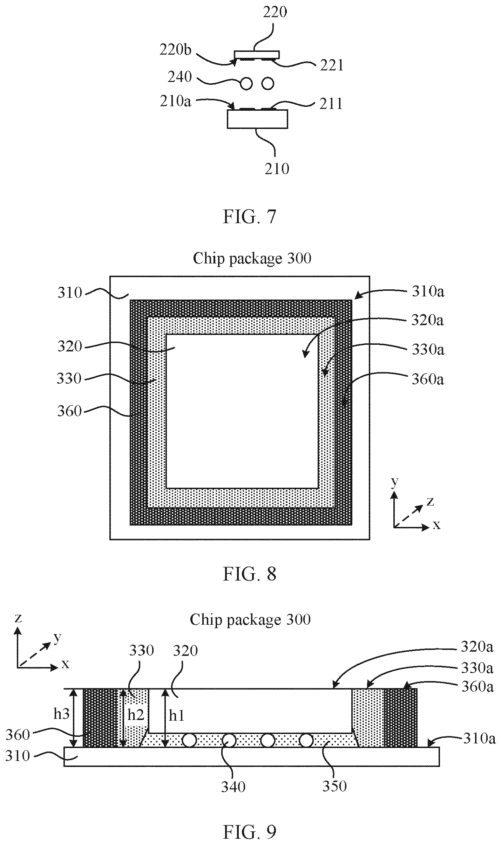

For example, FIG. 6 and FIG. 7 are schematic diagrams in which the die 220 is soldered on the substrate 210 by using the solder ball 240. As shown in FIG. 6 and FIG. 7, a pad 211 is disposed on the surface 210a of the substrate 210, a pad 221 is disposed on the surface 220b of the die 220, and the pad 211 and the pad 221 are soldered together by using the solder ball 240.

It should be noted that in FIG. 6 and FIG. 7, only four pads 211, four solder balls 240, and four pads 221 are used as an example for description. Neither a quantity of pads nor a quantity of solder balls is limited in this embodiment of this application.

In a possible implementation, in the chip package 200, a second protection structure 250 may be further added between the substrate 210 and the die 220.

For example, as shown in FIG. 5, the second protection structure 250 is added to a gap other than the solder ball 240 between the substrate 210 and the die 220.

In the chip package 200 provided in this embodiment of this application, the second protection structure 250 is added between the substrate 210 and the die 220, so that a case in which the die cracks due to uneven stress caused by a material difference between the substrate and the die can be avoided. In addition, a pad of the substrate 210 and the die 220 and a solder ball used for an electrical connection to the pad can be prevented from being polluted by moisture or other impurities, thereby improving reliability and safety of the chip package.

In a possible implementation, a material of the first protection structure 230 is different from a material of the second protection structure 250.

For example, viscosity of the material of the first protection structure 230 is different from viscosity of the material of the second protection structure 250.

Further, the viscosity of the material of the first protection structure 230 may be greater than the viscosity of the material of the second protection structure 250.

It should be noted that the first protection structure 230 is mainly used to fasten and protect the die 220, and the second protection structure 250 is mainly used to fill the gap between the substrate 210 and the die 220 and reduce impact on the die caused due to stress brought by a material difference between the die and the substrate. Therefore, the material of the first protection structure 230 may have higher viscosity, and the material of the second protection structure 250 may have lower viscosity. In other words, the viscosity of the material of the first protection structure 230 may be greater than the viscosity of the material of the second protection structure 250.

It should be noted that, for a part that is not described in FIG. 5, refer to descriptions of a corresponding part in FIG. 2 to FIG. 4. To avoid repetition, details are not described herein again.

In a possible implementation, FIG. 8 and FIG. 9 are schematic diagrams of a structure of a chip package 300 according to an embodiment of this application. FIG. 8 is a top view, and FIG. 9 is a front view. As shown in FIG. 8 and FIG. 9, the chip package 300 may include a substrate 310, a die 320, a first protection structure 330, a second protection structure 350 (shown in FIG. 9 but not shown in FIG. 8), and a blocking structure 360. The die 320, the first protection structure 330, the second protection structure 350, and the blocking structure 360 are all disposed on a surface 3 10a of the substrate 310 (that is, a first surface of the substrate).

The first protection structure 330 wraps a side surface of the die 320, the blocking structure 360 wraps a surface that is of the first protection structure 330 and that is away from the die 320, and the second protection structure 350 is added to a gap other than a solder ball 340 (shown in FIG. 9 but not shown in FIG. 8) between the substrate 310 and the die 320. A surface 320a of the die 320 (that is, a first surface of the die), a surface 330a of the first protection structure 330 (that is, a first surface of the first protection structure), and a surface 360a of the blocking structure 360 (that is, a first surface of the blocking structure) are flush. The surface 320a is a surface that is of the die 320 and that is away from the substrate 310, the surface 330a is a surface that is of the first protection structure 330 and that is away from the substrate 310, and the surface 360a is a surface that is of the blocking structure 360 and that is away from the substrate 310.

In a possible implementation, as shown in FIG. 9, that the surface 320a of the die 320, the surface 330a of the first protection structure 330, and the surface 360a of the blocking structure 360 are flush may be understood as follows: A distance h1 between the surface 320a of the die 320 and the surface 310a of the substrate 110, a distance h2 between the surface 330a of the first protection structure 330 and the surface 310a of the substrate 110, and a distance h3 between the surface 360a of the blocking structure 360 and the surface 310a of the substrate 110 are equal.

Optionally, there may be a plurality of dies in each of the chip package 100, the chip package 200, and the chip package 300, and orthographic projections of the plurality of dies on the substrate do not overlap with each other. This is not limited in embodiments of this application.

Optionally, when there are a plurality of dies in each of the chip package 200 and the chip package 300, correspondingly, there may be a plurality of second protection structures. This is not limited in embodiments of this application.

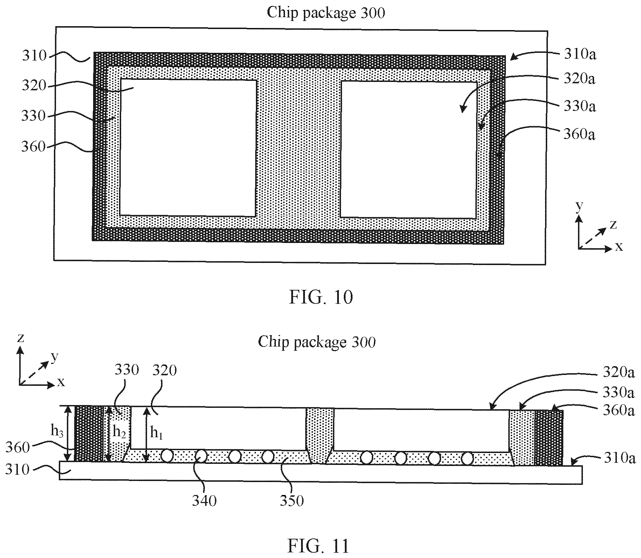

In a possible implementation, a chip 300 is used as an example. FIG. 10 and FIG. 11 are other schematic diagrams of a structure of a chip package 300 according to an embodiment of this application. FIG. 10 is a top view, and FIG. 11 is a front view. As shown in FIG. 10 and FIG. 11, the chip package 300 may include a plurality of dies 320 and a plurality of second protection structures 350 (shown in FIG. 11 but not shown in FIG. 10). A first protection structure 330 wraps a side surface of each of the plurality of dies 320, a blocking structure 360 wraps a surface that is of the first protection structure 330 and that is away from the plurality of dies 320, and a gap other than a solder ball 340 (shown in FIG. 11 but not shown in FIG. 10) between a substrate 310 and each die 320 is filled with a second protection structure 350. A surface 320a of each die 320 (that is, a first surface of the die), a surface 330a of the first protection structure 330 (that is, a first surface of the first protection structure), and a surface 360a of the blocking structure 360 (that is, a first surface of the blocking structure) are flush. The surface 320a is a surface that is of the die 320 and that is away from the substrate 310, the surface 330a is a surface that is of the first protection structure 330 and that is away from the substrate 310, and the surface 360a is a surface that is of the blocking structure 360 and that is away from the substrate 310.

It should be noted that, for a part that is not described in FIG. 10 and FIG. 11, refer to descriptions of a corresponding part in FIG. 2 to FIG. 9. To avoid repetition, details are not described herein again.

It should be further noted that in FIG. 10 and FIG. 11, only two dies are used as an example for description. A specific quantity of the plurality of dies is not limited in this embodiment of this application.

In the chip package 300 provided in this embodiment of this application, one first protection structure 330 and one blocking structure 360 may protect a plurality of dies 320, so that manufacturing process complexity and manufacturing costs can be reduced.

Optionally, when there are a plurality of dies in each of the chip package 100, the chip package 200, and the chip package 300, correspondingly, there may be a plurality of first protection structures and a plurality of blocking structures. This is not limited in embodiments of this application.

In a possible implementation, there may be a plurality of first protection structures, each of the plurality of first protection structures wraps at least one of the plurality of dies, and different first protection structures wrap different dies.

In other words, each of the plurality of first protection structures may wrap one or more dies, and different first protection structures wrap different dies.

In another possible implementation, there may be a plurality of blocking structures, a quantity of the plurality of blocking structures is equal to a quantity of the plurality of first protection structures, and each of the plurality of blocking structures wraps a first protection structure corresponding to the blocking structure.

In other words, different blocking structures wrap different first protection structures.

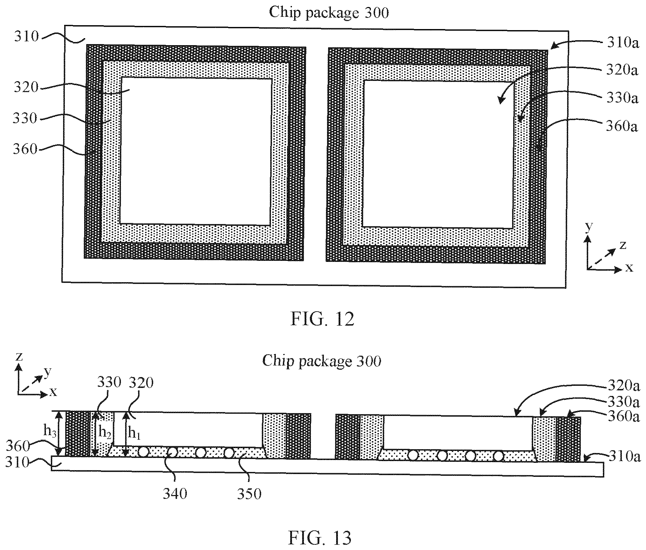

For example, a chip package 300 is used as an example. FIG. 12 and FIG. 13 are still other schematic diagrams of a structure of a chip package 300 according to an embodiment of this application. FIG. 12 is a top view, and FIG. 13 is a front view. As shown in FIG. 12 and FIG. 13, the chip package 300 includes a substrate 310, a plurality of dies 320, a plurality of first protection structures 330, a plurality of second protection structures 350 (shown in FIG. 13 but not shown in FIG. 12), and a plurality of blocking structures 360. The plurality of dies 320, the plurality of first protection structures 330, the plurality of second protection structures 350, and the plurality of blocking structures 360 are all disposed on a surface 3 10a of the substrate 310 (that is, a first surface of the substrate).

Different first protection structures 330 wrap different dies 320, different blocking structures 360 wrap different first protection structures 330, and different second protection structures 350 are added to gaps other than solder balls 340 (shown in FIG. 13 but not shown in FIG. 12) between the substrate 310 and different dies 320. A surface 320a of each die 320 (that is, a first surface of the die), a surface 330a of each first protection structure 330 (that is, a first surface of the first protection structure), and a surface 360a of each blocking structure 360 (that is, a first surface of the blocking structure) are flush. The surface 320a is a surface that is of the die 320 and that is away from the substrate 310, the surface 330a is a surface that is of the first protection structure 330 and that is away from the substrate 310, and the surface 360a is a surface that is of the blocking structure 360 and that is away from the substrate 310.

It should be noted that, when surfaces 320a of some or all of the plurality of dies 320 are not flush, in the manner shown in FIG. 12 and FIG. 13, an independent first protection structure 330 and an independent blocking structure 360 are disposed for at least one die 320 with a flush surface 320a in the plurality of dies 320, to ensure that each die 320 and an edge of a first protection structure 350 that wraps the die are completely covered, thereby ensuring heat dissipation performance and stability of each die 320, and improving reliability of the chip package.

It should be noted that in FIG. 12 and FIG. 13, only two dies, two first protection structures, and two blocking structures are used as an example for description. Specific quantities of the plurality of dies, the plurality of first protection structures, and the plurality of blocking structures are not limited in this embodiment of this application.

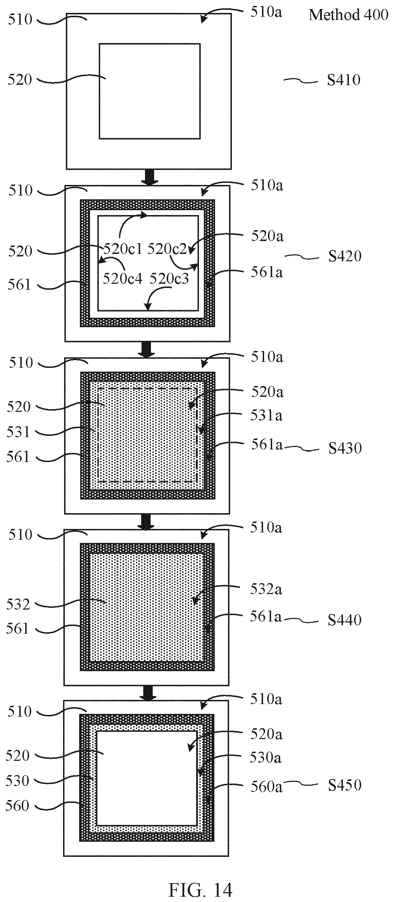

The foregoing describes the chip package in embodiments of this application with reference to FIG. 2 to FIG. 13. The following describes a chip package preparation method in embodiments of this application with reference to FIG. 14 to FIG. 16.

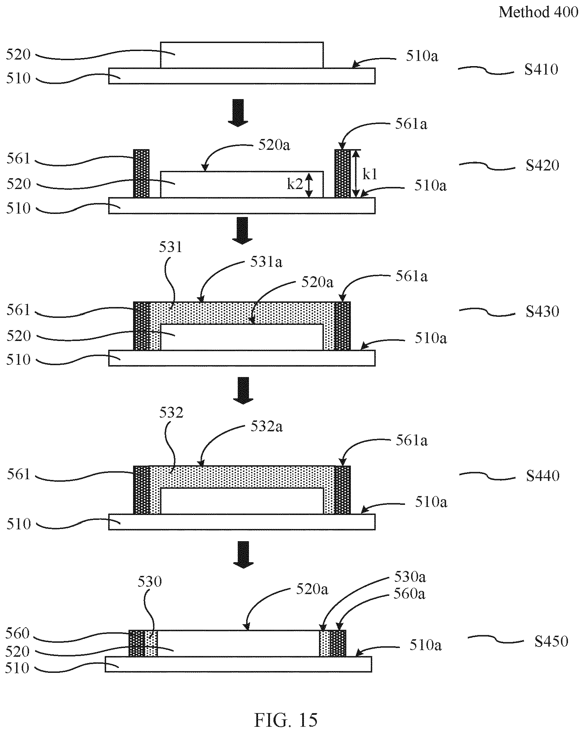

FIG. 14 and FIG. 15 are schematic flowcharts of a preparation method 400 according to an embodiment of this application. FIG. 14 is a top view, and FIG. 15 is a front view. As shown in FIG. 14 and FIG. 15, the preparation method 400 includes the following steps.

S410: Dispose a die 520 on a surface 510a of a substrate 510 (that is, a first surface of the substrate).

S420: Dispose a first blocking structure 561 around a side surface 520c1, a surface 520c2, a surface 520c3, and a surface 520c4 of the die 520 on the surface 510a, where there is a gap between the first blocking structure 561 and each of the side surface 520c1, the surface 520c2, the surface 520c3, and the surface 520c4 of the die 520, a distance k1 between a surface 561a of the first blocking structure 561 (that is, a first surface of the first blocking structure 561) and the surface 510a is greater than a distance k2 between a surface 520a of the die (that is, a first surface of the die) and the surface 510a, the surface 561a is a surface that is of the first blocking structure 561 and that is away from the substrate 510, and the surface 520a is a surface that is of the die 520 and that is away from the substrate 510.

It should be noted that, that there is the gap between the first blocking structure 561 and the side surface of the die 520 may be understood as that a surface that is of the first blocking structure 561 and that is close to the die 520 and a surface that is of the die 520 and that is close to the first blocking structure 561 do not directly touch.

It should be further noted that, k1 may be understood as a distance between a lowest point of the surface 561a and the surface 510a, or a distance between a lowest point on a side that is of the surface 561a and that is close to the die and the surface 510a.

S430: Fill a surrounding range of the first blocking structure 561 with a first filling material 531, until a surface 531a of the first filling material 531 (that is, a first surface of the filling material) is flush with the surface 561a of the first blocking structure 561, where the surface 531a is a surface that is of the first filling material 531 and that is away from the substrate 510.

In a possible implementation, in S430, the surrounding range of the first blocking structure 561 may be filled with the first filling material 531 through glue dispensing.

S440: Heat and solidify the first filling material 531, to form a third protection structure 532.

S450: Grind a surface 532a of the third protection structure 532 (that is, a first surface of the third protection structure) and the surface 561a of the first blocking structure 561, until the surface 520a of the die 520 is exposed, where the third protection structure 532 forms a first protection structure 530, the first blocking structure 561 forms a blocking structure 560, and the surface 520a of the die 520, a surface 530a of the first protection structure 530, and a surface 560a of the blocking structure 560 are flush.

Further, after the surface 520a of the die 520 is exposed, the surface 532a of the third protection structure 532, the surface 561a of the first blocking structure 561, and the surface 520a of the die 520 may be further ground to some extent, to ensure that the surface 532a, the surface 561a, and the surface 520a are flush.

It should be noted that, S410 to S450 show merely an example of a chip package preparation method when there is one die, one first protection structure, and one blocking structure. When there are a plurality of dies, or there are a plurality of dies, a plurality of first protection structures, and a plurality of blocking structures, for a chip package preparation method, refer to S410 to S450. To avoid repetition, details are not described herein again.

In a possible implementation, when there are a plurality of dies 520, S410 may include: disposing the plurality of dies 520 on the surface 510a, where orthographic projections of the plurality of dies 520 on the surface 510a do not overlap with each other.

Correspondingly, when there are a plurality of first blocking structures 561, S420 may include: disposing the plurality of first blocking structures 561 on the first surface 510a, where each of the plurality of first blocking structures 561 surrounds at least one of the plurality of dies 520, and a different first blocking structure 561 surrounds different dies 520.

Correspondingly, S430 may include: filling, with the first filling material 531, a gap between each first blocking structure 561 and the at least one die 520 surrounded by each first blocking structure 561.

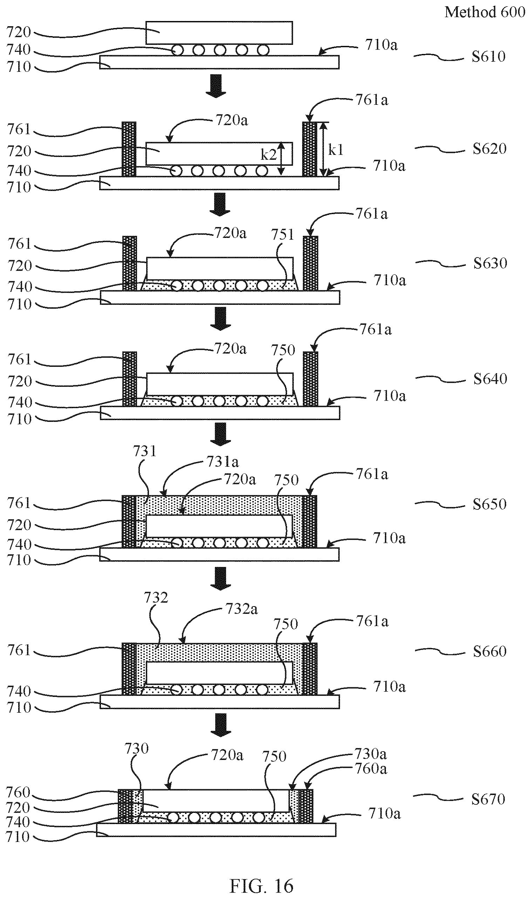

FIG. 16 is a schematic flowchart of a preparation method 600 according to an embodiment of this application. As shown in FIG. 16, the preparation method 600 includes the following steps.

S610: Solder a die 720 on a surface 710a of a substrate 710 (that is, a first surface of the substrate) by using a solder ball 740.

S620: Dispose a first blocking structure 761 around a side surface (including a surface 720c1, a surface 720c2, a surface 720c3, and a surface 720c4) of the die 720 on the surface 710a, where there is a gap between the first blocking structure 761 and each of the surface 720c1, the surface 720c2, the surface 720c3, and the surface 720c4 of the die 720, a distance k1 between a surface 761a of the first blocking structure 761 (that is, a first surface of the first blocking structure 761) and the surface 710a is greater than a distance k2 between a surface 720a of the die (that is, a first surface of the die) and the surface 710a, the surface 761a is a surface that is of the first blocking structure 761 and that is away from the substrate 710, and the surface 720a is a surface that is of the die 720 and that is away from the substrate 710.

It should be noted that, that there is the gap between the first blocking structure 761 and the side surface of the die 720 may be understood as that a surface that is of the first blocking structure 761 and that is close to the die 720 and a surface that is of the die 720 and that is close to the first blocking structure 761 do not directly touch.

It should be further noted that, k1 may be understood as a distance between a lowest point of the surface 761a and the surface 710a, or a distance between a lowest point on a side that is of the surface 761a and that is close to the die and the surface 710a.

S630: Fill a gap other than the solder ball 740 between the substrate 710 and the die 720 with a second filling material 751.

In a possible implementation, in S630, the gap other than the solder ball 740 between the substrate 710 and the die 720 may be filled with the second filling material 751 through glue dispensing.

S640. Heat and solidify the second filling material 751, to form a second protection structure 750.

S650: Fill a surrounding range of the first blocking structure 761 with a first filling material 731, until a surface 731a of the first filling material 731 (that is, a first surface of the first filling material) is flush with the surface 761a of the first blocking structure 761, where the surface 731a is a surface that is of the first filling material 731 and that is away from the substrate 710.

In a possible implementation, in S650, the surrounding range of the first blocking structure 761 may be filled with the first filling material 731 through glue dispensing.

S660: Heat and solidify the first filling material 731, to form a third protection structure 732.

S670: Grind a surface 732a of the third protection structure 732 (that is, a first surface of the third protection structure) and the surface 761a of the first blocking structure 761, until the surface 720a of the die 720 is exposed, where the third protection structure 732 forms a first protection structure 730, the first blocking structure 761 forms a blocking structure 760, and the surface 720a of the die 720, a surface 730a of the first protection structure 730, and a surface 760a of the blocking structure 760 are flush.

Further, after the surface 720a of the die 720 is exposed, the surface 732a of the third protection structure 732, the surface 761a of the first blocking structure 761, and the surface 720a of the die 720 may be further ground, to ensure that the surface 732a, the surface 761a, and the surface 720a are flush.

It should be noted that, S610 to S670 show merely an example of a chip package preparation method when there is one die, one first protection structure, and one blocking structure. When there are a plurality of dies, or there are a plurality of dies, a plurality of first protection structures, and a plurality of blocking structures, for a chip package preparation method, refer to S610 to S670. To avoid repetition, details are not described herein again.

In a possible implementation, when there are a plurality of dies 720, S610 may include: soldering the plurality of dies 720 on the surface 710a of the substrate 710 by using the solder ball 740, where orthographic proj ections of the plurality of dies 720 on the surface 710a do not overlap with each other.

Correspondingly, when there are a plurality of first blocking structures 761, S620 may include: disposing the plurality of first blocking structures 761 on the first surface 710a, where each of the plurality of first blocking structures 761 surrounds at least one of the plurality of dies 720, and a different first blocking structure 761 surrounds different dies 720.

Correspondingly, S630 may include: filling a gap other than the solder ball 740 between the substrate 710 and the plurality of dies 720 with the second filling material 751.

Correspondingly, S650 may include: filling, with the first filling material 731, a gap between each first blocking structure 761 and the at least one die 720 surrounded by each first blocking structure 761.

The foregoing describes, with reference to FIG. 14 to FIG. 16, the chip package preparation method provided in embodiments of this application. The following describes an integrated circuit integrated with the chip package provided in embodiments of this application.

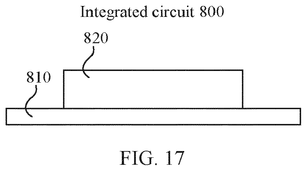

FIG. 17 is a schematic diagram of a structure of an integrated circuit 800 according to an embodiment of this application. As shown in FIG. 17, the integrated circuit 800 includes a PCB 810 and a chip package 820, and the chip package 820 is integrated on the PCB 810.

It should be noted that, for a structure of the chip package 820, refer to the chip package described in any embodiment in embodiments of this application. To avoid repetition, details are not described herein again.

"First", "second", or the like mentioned in this specification does not indicate any order, quantity, or importance, but is used only for distinguishing between different components. Likewise, "a/an", "one", or the like is not intended to indicate a quantity limitation either, but is intended to indicate existing at least one. "Connection", "link", or the like is not limited to a physical or mechanical connection, but may include an electrical connection, whether directly or indirectly.

In embodiments of this application, words such as "in a possible implementation" or "for example" are used to represent giving examples, illustrations, or descriptions. Any embodiment or design solution described as "in a possible implementation" or "for example" in embodiments of this application should not be construed as being more advantageous than other embodiments or design solutions. Specifically, the words such as "in a possible implementation" or "for example" are used to present related concepts in a specific manner.

In the descriptions of embodiments of this application, unless otherwise stated, "a plurality of" means two or more. For example, a plurality of dies refer to two or more dies.

The foregoing descriptions are merely specific implementations of this application. However, the protection scope of this application is not limited thereto. Any change or replacement readily figured out by a person skilled in the art within the technical scope disclosed in this application shall fall within the protection scope of this application. Therefore, the protection scope of this application shall be subject to the protection scope of the claims.

## Claims

1. A chip package, comprising a substrate, a die, a first protection structure, and a blocking structure, wherein
the die, the first protection structure, and the blocking structure are all disposed on a first surface of the substrate; and
the first protection structure wraps a side surface of the die, the blocking structure wraps a surface that is of the first protection structure and that is away from the die, and a first surface of the die, a first surface of the first protection structure, and a first surface of the blocking structure are flush, wherein the first surface of the die is a surface that is of the die and that is away from the substrate, the first surface of the first protection structure is a surface that is of the first protection structure and that is away from the substrate, and the first surface of the blocking structure is a surface that is of the blocking structure and that is away from the substrate.

2. The chip package according to claim 1, wherein a second protection structure is added between the substrate and the die.

3. The chip package according to claim 2, wherein
a material of the first protection structure is different from a material of the second protection structure.

4. The chip package according to claim 3, wherein
viscosity of the material of the first protection structure is greater than viscosity of the material of the second protection structure.

5. The chip package according to any one of claims 1 to 4, wherein
there are a plurality of dies, and orthographic projections of the plurality of dies on the first surface of the substrate do not overlap with each other.

6. The chip package according to claim 5, wherein
there are a plurality of first protection structures, each of the plurality of first protection structures wraps at least one of the plurality of dies, and different first protection structures wrap different dies.

7. The chip package according to claim 6, wherein
there are a plurality of blocking structures, a quantity of the plurality of blocking structures is equal to a quantity of the plurality of first protection structures, and the plurality of blocking structures separately wrap the plurality of first protection structures.

8. An integrated circuit, comprising a printed circuit board PCB and the chip package according to any one of claims 1 to 7 that is disposed on the PCB.

9. A chip package preparation method, comprising:
disposing a die on a first surface of a substrate;
disposing a first blocking structure around a side surface of the die on the first surface of the substrate, wherein there is a gap between the first blocking structure and the die, a distance between a first surface of the first blocking structure and the first surface of the substrate is greater than a distance between a first surface of the die and the first surface of the substrate, the first surface of the first blocking structure is a surface that is of the first blocking structure and that is away from the substrate, and the first surface of the die is a surface that is of the die and that is away from the substrate;
filling the gap between the first blocking structure and the die with a first filling material, until a first surface of the first filling material is flush with the first surface of the first blocking structure, wherein the first surface of the first filling material is a surface that is of the first filling material and that is away from the substrate;
heating and solidifying the first filling material to form a third protection structure; and
grinding a first surface of the third protection structure and the first surface of the first blocking structure, until the first surface of the die is exposed.

10. The preparation method according to claim 9, wherein before the filling the gap between the first blocking structure and the die with a first filling material, the preparation method further comprises:
adding a second filling material between the die and the substrate; and
heating and solidifying the second filling material to form a second protection structure.

11. The preparation method according to claim 10, wherein
a material of the third protection structure is different from a material of the second protection structure.

12. The preparation method according to claim 11, wherein
viscosity of the material of the third protection structure is greater than viscosity of the material of the second protection structure.

13. The preparation method according to any one of claims 9 to 12, wherein there are a plurality of dies, and the disposing a die on a first surface of a substrate comprises:
disposing the plurality of dies on the first surface of the substrate, wherein orthographic projections of the plurality of dies on the first surface of the substrate do not overlap with each other.

14. The preparation method according to claim 13, wherein there are a plurality of first blocking structures, and the disposing a first blocking structure around a side surface of the die on the first surface of the substrate comprises:
disposing the plurality of first blocking structures on the first surface of the substrate, wherein each of the plurality of first blocking structures surrounds a side surface of at least one of the plurality of dies, and a different first blocking structure surrounds different dies.

15. The preparation method according to claim 14, wherein the filling the gap between the first blocking structure and the die with a first filling material comprises:
filling, with the first filling material, a gap between each first blocking structure and the at least one die surrounded by each first blocking structure.
